(19) Europäisches Patentamt / European Patent Office / Office européen des brevets

(11) **EP 4 764 521 A1**

(12) **EUROPEAN PATENT APPLICATION**
published in accordance with Art. 153(4) EPC

(43) Date of publication:
**24.06.2026 Bulletin 2026/26**

(21) Application number: **24905096.4**

(22) Date of filing: **05.12.2024**

(51) International Patent Classification (IPC):
**G01R 31/36** (2020.01)

(86) International application number:
**PCT/CN2024/137238**

(87) International publication number:
**WO 2026/065755 (02.04.2026 Gazette 2026/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.09.2024 CN 202411390872**

(71) Applicant: Eve Energy Co. Ltd.
Huizhou, Guangdong 516000 (CN)

(72) Inventors:
• WAN, Liping
Huizhou, Guangdong 516006 (CN)
• LI, Yaling
Huizhou, Guangdong 516006 (CN)

(74) Representative: Herrero & Asociados, S.L.
Edificio Aqua - Calle Agustín de Foxá, 4-10, 2ºA
28036 Madrid (ES)

(54) **METHOD AND APPARATUS FOR ESTIMATING SOC AND SOH OF LITHIUM-ION BATTERY, AND COMPUTER STORAGE MEDIUM**

(57) The present disclosure discloses a method and a device for estimating an SOC and an SOH of a lithium-ion battery, and a computer storage medium. The method includes: collecting battery output information of lithium-ion batteries at preset time intervals during a life cycle experiment on the lithium-ion batteries, then calculating a voltage drop per unit time corresponding to the lithium-ion battery, and constructing an SOC calculation model of the lithium-ion battery based on the battery output information and the voltage drop per unit time, defining a correction factor according to the SOC calculation model, and constructing an SOH calculation model of the lithium-ion battery according to the battery output information, the voltage drop per unit time and the correction factor.

Collecting battery output information of lithium-ion batteries at preset time intervals during a life cycle experiment on the lithium-ion batteries — 201

In an output voltage at each collection moment, calculating a voltage drop per unit time corresponding to the lithium-ion battery based on two adjacent output voltages — 202

Determining an initial voltage of the lithium-ion battery, and calculating an over-potential of the lithium-ion battery after ageing according to the output voltage at each collection moment and the initial voltage — 203

Calculating a resistance change of the lithium-ion battery after aging according to the output current at each collection moment and the over-potential — 204

Calculating the voltage drop per unit time corresponding to the lithium-ion battery according to the resistance change and the output current at each collection moment — 205

Constructing an SOC calculation model of the lithium-ion battery based on the battery output information and the voltage drop per unit time — 206

Defining a correction factor according to the SOC calculation model, and constructing an SOH calculation model of the lithium-ion battery according to the battery output information, the voltage drop per unit time and the correction factor — 207

FIG. 2

EP 4 764 521 A1

## Description

The present disclosure claims priority to Chinese Patent Application No. 202411390872.3, filed with the Chinese Patent Office on September 30, 2024, the disclosure of which is incorporated herein by reference in its entirety.

## TECHNICAL FIELD

The present disclosure relates to the technical field of batteries, and in particular, to a method and a device for estimating an SOC and an SOH of a lithium-ion battery, and a computer storage medium.

## BACKGROUND

With the continuous development and progress of battery technologies, batteries are increasingly widely used in people's production and life. Lithium-ion batteries, as a rechargeable battery with high energy density and long cycle life, have been widely used in many fields, such as electric vehicles and smart electric devices. Therefore, a method for estimating a state of charge (SOC) and a state of health (SOH) of lithium batteries has become a hot research topic.

## TECHNICAL PROBLEM

At present, methods for estimating the SOC of lithium batteries in industry mainly include data-driven-based methods and model-based methods. However, the data-driven-based methods need to rely on the accuracy of a current sensor or need sufficient rest time for the battery, which are relatively low in measurement accuracy and efficiency. The model-based methods are only applicable to new batteries. The methods for estimating the SOH of lithium batteries in industry mainly include data-driven-based methods and adaptive-system-based methods. However, the data-driven-based methods need to evaluate large data sets by physical analysis to determine correlations between battery operation and degradation. The adaptive-system-based methods need to determine the SOH of the battery by calculating parameters that are sensitive to battery degradation. Both methods have poor computational load and real-time performance. Therefore, it is very important to propose a technical solution capable of improving the accuracy of online estimation of the SOC and the SOH of a lithium-ion battery.

## TECHNICAL SOLUTION

According to a first aspect, the present disclosure provides a method for estimating an SOC and an SOH of a lithium-ion battery. The method includes:

collecting battery output information of lithium-ion batteries at preset time intervals during a life cycle experiment on the lithium-ion batteries; wherein the battery output information includes an output current and an output voltage at each acquisition moment;

calculating a voltage drop per unit time corresponding to the lithium-ion battery according to the battery output information, and constructing an SOC calculation model of the lithium-ion battery based on the battery output information and the voltage drop per unit time; and

defining a correction factor according to the SOC calculation model, and constructing an SOH calculation model of the lithium-ion battery according to the battery output information, the voltage drop per unit time and the correction factor; wherein the SOC calculation model is configured to calculate SOC values of the lithium-ion batteries, and the SOH calculation model is configured to calculate SOH values of the lithium-ion batteries.

According to a second aspect, the present disclosure provides an device for estimating an SOC and an SOH of a lithium-ion battery. The apparatus includes:

a memory storing executable program codes;

a processor coupled to the memory;

where the processor calls the executable program codes stored in the memory to execute the method for estimating the SOC and the SOH of the lithium-ion battery disclosed in the first aspect of the present disclosure.

According to a third aspect, the present disclosure provides a computer storage medium. The computer storage medium stores computer instructions. When the computer instructions are called, the computer instructions are configured to execute the method for estimating the SOC and the SOH of the lithium-ion battery disclosed in the first aspect of the present disclosure.

## BENEFICIAL EFFECTS

The beneficial effects provided in the present disclosure are as follows: in the embodiments of the present disclosure, collecting the battery output information of the lithium-ion batteries at preset time intervals during the life cycle experiment on the lithium-ion batteries; calculating the voltage drop per unit time corresponding to the lithium-ion battery according to the battery output information, and constructing the SOC calculation model of the lithium-ion battery based on the battery output information and the voltage drop per unit time; defining the correction factor according to the SOC calculation model, and construct the SOH calculation model of the lithium-ion battery according to battery output information, the voltage drop per unit time and the correction factor. It can be seen that the implementation of the present disclosure can define the SOC model and the SOH model based on a voltage drop per unit time of a new variable, and the instantaneous SOC and SOH of the battery are estimated online without performing a full cycle test on the batteries, thereby improving the efficiency and accuracy of determining the SOC and the SOH of the battery. Furthermore, modeling can be performed based on any one of the batteries in the same batch, and then estimate the SOCs and the SOHs of all the batteries. The model has high accuracy and robustness, and can improve the accuracy of online estimation of the SOC and the SOH of the lithium-ion battery.

## BRIEF DESCRIPTION OF THE DRAWINGS

FIG. 1 is a schematic flowchart of a method for estimating an SOC and an SOH of a lithium-ion battery according to the embodiments of the present disclosure;
FIG. 2 is a schematic flowchart of another method for estimating an SOC and an SOH of a lithium-ion battery according to the embodiments of the present disclosure;
FIG. 3 is a schematic structural diagram of a device for estimating an SOC and an SOH of a lithium-ion battery according to the embodiments of the present disclosure;
FIG. 4 is a schematic structural diagram of another device for estimating an SOC and an SOH of a lithium-ion battery according to the embodiments of the present disclosure;
FIG. 5 is a schematic structural diagram of another device for estimating an SOC and an SOH of a lithium-ion battery according to the embodiments of the present disclosure.

## DETAILED DESCRIPTION

The present disclosure discloses a method and a device for estimating an SOC and an SOH of a lithium-ion battery, and a computer storage medium, which can define an SOC model and an SOH model based on a voltage drop per unit time of a new variable, and estimate the instantaneous SOC and SOH of the battery online without performing a full cycle test on the batteries, thereby improving the efficiency and accuracy of determining the SOC and the SOH of the battery. Furthermore, modeling can be performed based on any one of the batteries in a same batch, and then estimate the SOCs and the SOHs of all the batteries. The model has high accuracy and robustness, and can improve the accuracy of online estimation of the SOC and the SOH of the lithium-ion battery. Detailed descriptions are provided below.

Embodiment 1

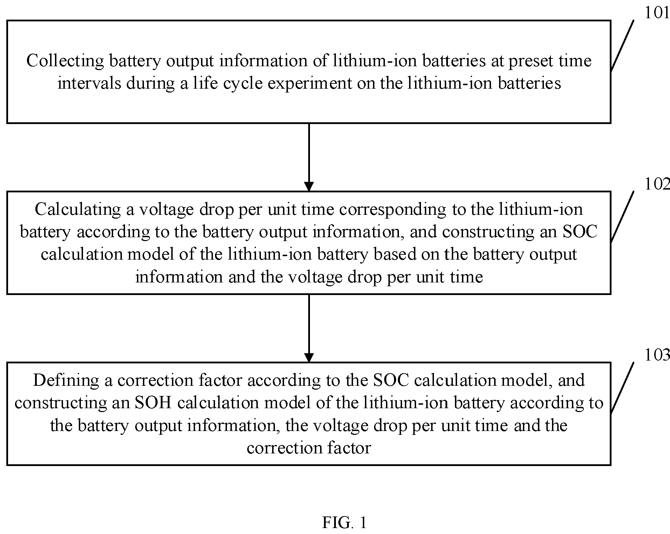

Please refer to FIG. 1, which 1 is a schematic flowchart of a method for estimating an SOC and an SOH of a lithium-ion battery according to the embodiments of the present disclosure. the method for estimating the SOC and the SOH of the lithium-ion battery described in FIG. 1 can be applied to a device for estimating an SOC and an SOH of a lithium-ion battery. the device for estimating the SOC and the SOH of the lithium-ion battery may include an intelligent server or an intelligent platform configured to estimate an SOC value and an SOH value of a lithium-ion battery. The intelligent server includes a local server or a cloud server, which is not limited in the embodiments of the present disclosure. As shown in FIG. 1, the method for estimating the SOC and the SOH of the lithium-ion battery may include the following operations:
101, collecting battery output information of lithium-ion batteries at preset time intervals during a life cycle experiment on the lithium-ion batteries.
In the embodiments of the present disclosure, optionally, during the life cycle experiment on the lithium-ion batteries, the preset time interval for collecting the battery output information of the lithium-ion batteries may be set by a tester according to actual needs. For example, collection may be performed every 30 seconds. The battery output information of the lithium-ion battery may include an output current and an output voltage of the lithium-ion battery at each collection moment. Furthermore, the lithium-ion batteries may be a plurality of batteries in a same batch of batteries, which is not limited in the present disclosure.

102, calculating a voltage drop per unit time corresponding to the lithium-ion battery according to the battery output information, and constructing an SOC calculation model of the lithium-ion battery based on the battery output information and the voltage drop per unit time.

In the embodiments of the present disclosure, optionally, the voltage drop per unit time may represent a voltage drop of lithium-ions within a unit time during a discharging process, and the SOC (State of Charge) represents a charging state of a battery, which is also commonly referred to as a remaining electric quantity or charging and discharging state. The most convenient and most direct output of a battery in use is a voltage, a current, and time. A single voltage value is never sufficient to identify the SOC of the battery because the voltage may vary as the battery ages. Therefore, a parameter of the voltage drop per unit time corresponding to the lithium-ion battery is proposed for establishing an SOC model and an SOH model. Test data shows that an average correlation between the battery SOC and the battery voltage is 0.988, and an average correlation between the battery SOC and an inverse of the voltage drop per unit time of the battery is 0.984. Therefore, the relationship between the SOC of the battery and the voltage and the inverse of the voltage drop per unit time is approximately linear, which is not limited in the present disclosure.

103, defining a correction factor according to the SOC calculation model, and constructing an SOH calculation model of the lithium-ion battery according to the battery output information, the voltage drop per unit time and the correction factor.

In the embodiments of the present disclosure, optionally, the SOH (State of Health) of the battery represents a health state of the battery, which is affected by capacity attenuation and impedance increase of the battery. The correction factor defined according to the SOC calculation model is set to enable the SOH calculation model of the battery to calculate the SOH of the battery based on the SOC of the battery. The influence of the SOH of the battery on the SOC varies with the variation of the SOH, which is not limited in the present disclosure.

It can be seen that the method for estimating the SOC and the SOH of the lithium-ion battery as described in FIG. 1 can collect the battery output information of the lithium-ion batteries at preset time intervals during the life cycle experiment on the lithium-ion batteries; calculate the voltage drop per unit time corresponding to the lithium-ion battery according to the battery output information, and construct the SOC calculation model of the lithium-ion battery based on the battery output information and the voltage drop per unit time; define the correction factor according to the SOC calculation model, and construct the SOH calculation model of the lithium-ion battery according to battery output information, the voltage drop per unit time and the correction factor. The SOC model and the SOH model can be defined based on a voltage drop per unit time of a new variable, and the instantaneous SOC and SOH of the battery are estimated online without performing a full cycle test on the batteries, thereby improving the efficiency and accuracy of determining the SOC and the SOH of the battery. Furthermore, modeling can be performed based on any one of the batteries in the same batch, and then estimate the SOCs and the SOHs of all the batteries. The model has high accuracy and robustness, and can improve the accuracy of online estimation of the SOC and the SOH of the lithium-ion battery.

In an optional embodiment, the constructing an SOH calculation model of the lithium-ion battery according to the battery output information, the voltage drop per unit time and the correction factor may include the following operations:

constructing an SOH regression model of the lithium-ion battery at a preset SOC level according to the battery output information and the voltage drop per unit time; and
constructing, based on the correction factor, the SOH calculation model of the lithium-ion battery based on the SOH regression model at the preset SOC level.

In the optional embodiment, optionally, according to the battery output information and the voltage drop per unit time, the SOH regression model of the lithium-ion battery at a certain SOC level is set as: $\text{SOH}(\%) = A * \left(\dfrac{1}{V'}\right) + B$ , in which A and B are coefficients to be determined. Based on the correction factor, the SOH calculation model of the lithium-ion battery is constructed based on the SOH regression model at the preset SOC level, namely, $\text{SOH}(\%) = \alpha(\text{SOC}) * \left[ A * \left(\dfrac{1}{V'}\right) + B \right]$ . That is, the SOH of the battery can be calculated based on the SOC of the battery, and the influence of the SOH of the battery on the SOC varies with the variation of the SOH.

It can be seen that the implementation of the optional embodiment can construct the SOH regression model of the lithium-ion battery at the preset SOC level according to the battery output information and the voltage drop per unit time; construct, based on the correction factor, the SOH calculation model of the lithium-ion battery based on the SOH regression model at the preset SOC level. The SOH calculation model can be constructed based on the correction factor newly defined in the SOC calculation model, thereby improving the accuracy of the SOH model, and improving the accuracy and efficiency of calculating the SOH of the battery at the same time.

In another optional embodiment, the constructing an SOH regression model of the lithium-ion battery at a preset SOC level according to the battery output information and the voltage drop per unit time may include the following operations:

performing a data regression fitting based on the battery output information to obtain SOH model coefficients of the lithium-ion battery; and
constructing the SOH regression model of the lithium-ion battery at the preset SOC level according to the voltage drop per unit time and the SOH model coefficients.

The SOH regression model includes:

$$\mathrm{SOH}(\%) = \mathrm{A} * \left(\frac{1}{\mathrm{V}'}\right) + \mathrm{B},$$

and the SOH calculation model includes:

$$\mathrm{SOH}(\%) = \alpha(\mathrm{SOC}) * \left[\mathrm{A} * \left(\frac{1}{\mathrm{V}'}\right) + \mathrm{B}\right],$$

where A and B represent the SOH model coefficients, and $\alpha$(SOC) represents the correction factor.

In this optional embodiment, optionally, a data regression fitting is performed based on the battery output information to obtain the SOH model coefficients A and B of the lithium-ion battery, and $\alpha$(SOC) represents the correction factor.

It can be seen that the implementation of the optional embodiment can construct the SOH regression model of the lithium-ion battery at the preset SOC level according to the voltage drop per unit time and the SOH model coefficients, and then construct the SOH calculation model based on the correction factor newly defined by the SOC calculation model, which can improve the accuracy of the SOH model, and improve the accuracy and efficiency of calculating the SOH of the battery at the same time.

In yet another optional embodiment, the defining a correction factor according to the SOC calculation model may include the following operations:

performing a data regression fitting based on the SOC calculation model and the battery output information to obtain correction factor coefficients of the lithium-ion battery; and
defining the correction factor based on the correction factor coefficients and the SOC calculation model.

A formula for calculating the correction factor includes:

$$\alpha(\mathrm{SOC}) = \mathrm{C}_1(\mathrm{SOC})^3 + \mathrm{C}_2(\mathrm{SOC})^2 + \mathrm{C}_3(\mathrm{SOC})^1 + \mathrm{C}_0,$$

where, $C_1$, $C_2$, $C_3$, and $C_0$ represent the correction factor coefficients.

In the optional embodiment, optionally, $\alpha$(SOC) is a correction factor newly defined based on SOC, which is a function of the SOC, and $\alpha$ does not change monotonically with the SOC, therefore, interpolation is required, and a cubic polynomial is accurate enough. Therefore, the formula for calculating the correction factor is $\alpha(\mathrm{SOC}) = C_1(\mathrm{SOC})^3 + C_2(\mathrm{SOC})^2 + C_3(\mathrm{SOC})^1 + C_0$, in which a data regression fitting can be performed based on the SOC calculation model and the battery output information to obtain the correction factor coefficients of the lithium-ion battery, and $C_1$, $C_2$, $C_3$, and $C_0$ represent the correction factor coefficients.

It can be seen that the implementation of the optional embodiment can perform a data regression fitting based on the SOC calculation model and the battery output information, so as to obtain the correction factor coefficients of the lithium-ion battery; and define the correction factor based on the correction factor coefficients and the SOC calculation model, which can improve the accuracy of the correction factor. In addition, the correction factor is introduced into the SOH calculation model, without the need to regress and calculate the model coefficients again, thereby improving the model accuracy and the calculation efficiency.

In still another optional embodiment, the method for estimating the SOC and the SOH of the lithium-ion battery may further include the following operations:

calculating battery test values of the lithium-ion battery according to the SOC calculation model and the SOH calculation model respectively, where the battery test values include an SOC test value and an SOH test value;

obtaining battery verification values of the lithium-ion battery, and calculating model indexes corresponding to the SOC calculation model and the SOH calculation model respectively according to the battery test values and the battery verification values, where the battery verification values include an SOC verification value and an SOH verification value, and the model indexes include an average correlation coefficient and a root mean square error; and

performing model verification on the SOC calculation model and the SOH calculation model respectively based on the model indexes corresponding to the SOC calculation model and the SOH calculation model to obtain a verification result, and performing model optimization on the SOC calculation model and the SOH calculation model based on the verification result.

In the optional embodiment, optionally, the battery test values include the SOC test value and the SOH test value, and the battery verification values of the lithium-ion battery include the SOC verification value and the SOH verification value, which are configured to verify the accuracy of the models. The model indexes include the average correlation coefficient and the root mean square error. A formula for calculating the average correlation coefficient is:

$$R^2 = \frac{SSR}{SST} = \frac{\sum(\hat{y}_i - \bar{y})^2}{\sum(y_i - \bar{y})^2}$$, and a formula for calculating the root mean square error is:

$$RMSE = \sqrt{\frac{1}{N}\sum_{i=1}^{n}(y_i - f(x_i))^2}$$. The root mean square error is the square root of the ratio of the square of a deviation between a predicted value and an actual value to the number n of observations, which measures the deviation between the predicted value and the actual value, with a high average correlation coefficient and a small root mean square error. The models are optimized based on the average correlation coefficient and the root mean square error. Four lithium-ion batteries A, B, C, and D from the same batch are used as experimental objects for a battery life cycle tests to obtain the battery output information. When the SOC calculation model and the SOH calculation model are constructed according to the battery output information of the lithium-ion battery A, and the SOC values and the SOH values of the four batteries are estimated respectively by using the SOC calculation model and the SOH calculation model, the average correlation coefficient and the root mean square error of SOC estimation for all batteries are as shown in Table 1 below:

Table 1:

| Battery No. | Correction | 100 cycles | 300 cycles | 500 cycles | 700 cycles |
|---|---|---|---|---|---|
| Battery A | R2 | 0.955 | 0.996 | 0.995 | 0.994 |
| | RMSE | 0.0105 | 0.0110 | 0.0112 | 0.0150 |
| Battery B | R2 | 0.996 | 0.995 | 0.995 | 0.0993 |
| | RMSE | 0.0154 | 0.0233 | 0.0150 | 0.0200 |
| Battery C | R2 | 0.994 | 0.995 | 0.994 | 0.994 |
| | RMSE | 0.0190 | 0.0100 | 0.0150 | 0.0200 |
| Battery D | R2 | 0.960 | 0.996 | 0.995 | 0.995 |
| | RMSE | 0.1220 | 0.0098 | 0.0100 | 0.0120 |

When the SOC calculation model and the SOH calculation model are constructed according to the battery output information of the lithium-ion battery A, and the SOC values and the SOH values of the four batteries are estimated respectively by using the SOC calculation model and the SOH calculation model, the average correlation coefficients and the root mean square errors of the batteries A, B, C, and D at a certain data point are as shown in Table 2 below:

Table 2:

| Statistical parameters | Battery A | Battery B | Battery C | Battery D |
|---|---|---|---|---|
| Data points | 42 | 36 | 39 | 41 |
| R2 | 0.990 | 0.980 | 0.954 | 0.946 |
| RMSE | 0.0262 | 0.0382 | 0.0352 | 0.0428 |

It can be seen that the SOC calculation model and the SOH calculation model show excellent accuracy when being used to estimate the four test batteries in the same batch, and use any one of the batteries in the same batch for model construction can result in similar accuracy for all four batteries. Optionally, the SOC calculation model may be used for an online SOC estimation within a voltage range of 3.55 V to 3.95 V, which is not limited in this embodiment.

It can be seen that the implementation of the optional embodiment can perform model verification and optimization on the SOC calculation model and the SOH calculation model based on the average correlation coefficient and the root mean square error, reducing the deviation between the model prediction value and the actual value, and when using any one of the batteries in the same batch for model construction, the accuracy and precision of calculating the SOC and the SOH of the other batteries are similar, thereby improving the accuracy and precision of the model.

Embodiment 2

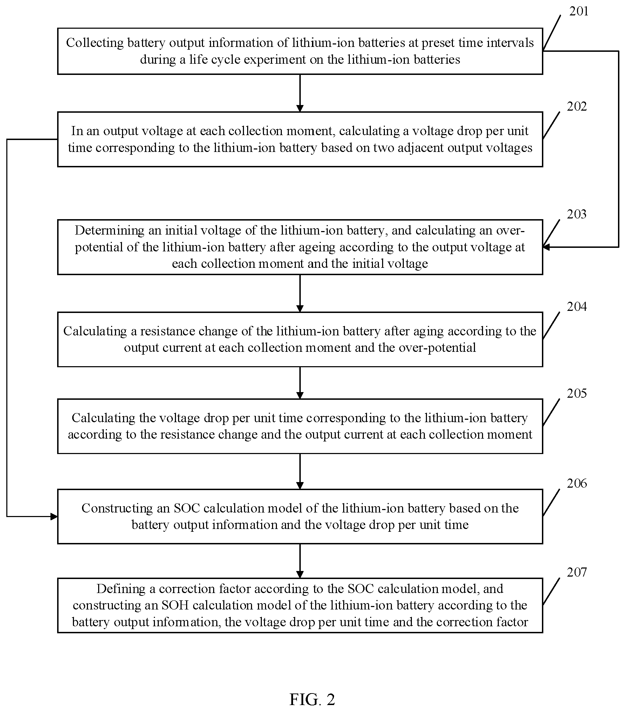

Please refer to FIG. 2, which is a schematic flowchart of a method for estimating an SOC and an SOH of a lithium-ion battery according to the embodiments of the present disclosure. the method for estimating the SOC and the SOH of the lithium-ion battery described in FIG. 2 can be applied to a device for estimating an SOC and an SOH of a lithium-ion battery. the device for estimating the SOC and the SOH of the lithium-ion battery may include an intelligent server or an intelligent platform configured to estimate an SOC value and an SOH value of a lithium-ion battery. The intelligent server includes a local server or a cloud server, which is not limited in the embodiments of the present disclosure. As shown in FIG. 2, the method for estimating the SOC and the SOH of the lithium-ion battery may include the following operations:

201, collecting battery output information of the lithium-ion batteries at preset time intervals during a life cycle experiment on lithium-ion batteries.
202, in an output voltage at each collection moment, calculating a voltage drop per unit time corresponding to the lithium-ion battery based on two adjacent output voltages.

In the embodiment of the present disclosure, optionally, the voltage drop per unit time corresponding to the lithium-ion battery is calculated based on two adjacent output voltages, that is, the voltage drop per unit time corresponding to the lithium-ion battery $V' = \dfrac{\Delta V}{\Delta t}$ , in which $\Delta V$ represents a difference value between two consecutive output voltages during a discharging process of the lithium-ion battery, that is, $\Delta V = V1 - V2$.

203, determining an initial voltage of the lithium-ion battery, and calculating an over-potential of the lithium-ion battery after ageing according to the output voltage at each collection moment and the initial voltage.

In the embodiment of the present disclosure, optionally, the initial voltage of the lithium-ion battery may represent an initial voltage when the lithium-ion battery leaves a factory, that is, the voltage before the lithium-ion battery ages. The over-potential after the lithium-ion battery is aged may represent an aging voltage of the lithium-ion battery. A relationship among the initial voltage, the output voltage, and the over-potential of the lithium-ion battery may be:

$$V(\text{terminal}) = V_{eg} + \eta$$

where, V(terminal) represents the initial voltage of the lithium-ion battery; $V_{eg}$ represents the output voltage of the lithium-ion battery; and $\eta$ represents the over-potential of the lithium-ion battery, including reversible and irreversible parts, which represents the degree of deviation from an equilibrium voltage.

204, calculating a resistance change of the lithium-ion battery after aging according to the output current at each collection moment and the over-potential.

In the embodiment of the present disclosure, optionally, a corresponding voltage drop during the discharging process of the lithium-ion battery may be approximately replaced by an over-potential of the lithium-ion battery, that is, $V' = \dfrac{\Delta V}{\Delta t} \approx \dfrac{\Delta \eta}{\Delta t}$ , then the resistance change of the lithium-ion battery after aging is calculated based on the output current at each collection moment.

205, calculating the voltage drop per unit time corresponding to the lithium-ion battery according to the resistance change and the output current at each collection moment.

In the embodiment of the present disclosure, optionally, the voltage drop per unit time corresponding to the lithium-ion battery is calculated according to the resistance change and the output current at each collection moment, that is, $V' \approx \dfrac{I\Delta R}{\Delta t}$ . In this case, the SOC of the battery is associated with battery aging by using the voltage drop per unit time corresponding to the lithium-ion battery. Existing models mostly express the SOH of the battery with a cycle life N as the main ageing parameter. However, the battery seldom undergoes a complete charging/discharging cycle during operation, and the cycle life is difficult to track. Therefore, the voltage drop per unit time corresponding to the lithium-ion battery is used to associate the SOC of the battery with the battery ageing, which can remove the cycle life N and improve the accuracy of the model.

206, constructing an SOC calculation model of the lithium-ion battery based on the battery output information and the voltage drop per unit time.

207, defining a correction factor according to the SOC calculation model, and constructing an SOH calculation model of the lithium-ion battery according to the battery output information, the voltage drop per unit time, and the correction factor.

In the embodiment of the present disclosure, for other descriptions of step 201, step 206 and step 207, reference may be made to the detailed description of step 101 to step 103 in the first embodiment, and the embodiment of the present disclosure will not be repeated.

It can be seen that the method for estimating the SOC and the SOH of the lithium-ion battery as described in FIG. 2 can collect the battery output information of the lithium-ion batteries at preset time intervals during the life cycle experiment on the lithium-ion batteries; in an output voltage at each collection moment, calculate a voltage drop per unit time corresponding to the lithium-ion battery based on two adjacent output voltages; determine an initial voltage of the lithium-ion battery, and calculate an over-potential of the lithium-ion battery after ageing according to the output voltage at each collection moment and the initial voltage; calculate a resistance change of the lithium-ion battery after aging according to the output current at each collection moment and the over-potential; calculate the voltage drop per unit time corresponding to the lithium-ion battery according to the resistance change and the output current at each collection moment, so that the SOC of the battery can be associated with battery aging based on the voltage drop per unit time corresponding to the lithium-ion battery, avoiding using a battery cycle life parameter which is difficult to track to express the SOH of the battery, reducing the difficulty in determining the SOC and the SOH of the battery, and improving determination accuracy and efficiency; construct an SOC calculation model of the lithium-ion battery based on the battery output information and the voltage drop per unit time; define a correction factor according to the SOC calculation model, and construct an SOH calculation model of the lithium-ion battery according to the battery output information, the voltage drop per unit time and the correction factor. The SOC model and the SOH model can be defined based on a voltage drop per unit time of a new variable, and the instantaneous SOC and SOH of the battery are estimated online without performing a full cycle test on the battery, thereby improving the efficiency and accuracy of determining the SOC and the SOH of the battery. Furthermore, modeling can be performed based on any one of the batteries in the same batch, and then estimate the SOCs and the SOH of all the batteries. The model has high accuracy and robustness, and can improve the accuracy of online estimation of the SOC and the SOH of the lithium-ion battery.

In an optional embodiment, in the output voltage at each collection moment, a calculation formula for calculating the voltage drop per unit time corresponding to the lithium-ion battery based on two adjacent output voltages includes:

$$V' = \frac{\Delta V}{\Delta t}, \quad \Delta V = V1 - V2,$$

where V' represents the voltage drop per unit time, V1 and V2 represent the two adjacent output voltages, and $\Delta t$ represents the unit time.

A calculation formula for calculating the voltage drop per unit time corresponding to the lithium-ion battery according to the resistance change and the output current at each collection moment includes:

$$V' \approx \frac{\Delta \eta}{\Delta t}, \quad \frac{V'}{I} \approx \frac{\Delta \eta / I}{\Delta t} = \frac{\Delta R}{\Delta t}, \quad V' \approx \frac{I \Delta R}{\Delta t},$$

where $\Delta \eta$ represents the over-potential, I represents the output current at each collection moment, and $\Delta R$ represents the resistance change.

In this optional embodiment, optionally, $\Delta V$ represents a difference value between two consecutive output voltages during a discharging process of the lithium-ion battery, that is, $\Delta V = V1 - V2$. The initial voltage of the lithium-ion battery may represent an initial voltage when the lithium-ion battery leaves a factory, that is, the voltage before the lithium-ion battery ages. The over-potential after the lithium-ion battery is aged may represent an aging voltage of the lithium-ion battery. A relationship among the initial voltage, the output voltage, and the over-potential of the lithium-ion battery may be V(terminal) = $V_{eg}$ + $\eta$, where, V(terminal) represents the initial voltage of the lithium-ion battery, $V_{eg}$ represents the output voltage of the lithium-ion battery, and $\eta$ represents the over-potential of the lithium-ion battery. A corresponding voltage drop during the discharging process of the lithium-ion battery may be approximately replaced by an over-potential of the lithium-ion battery, that is, $V' = \dfrac{\Delta V}{\Delta t} \approx \dfrac{\Delta \eta}{\Delta t}$ , substituting the output current at each collection moment of the lithium-ion battery into the formula to obtain $\dfrac{V'}{I} \approx \dfrac{\Delta \eta / I}{\Delta t} = \dfrac{\Delta R}{\Delta t}$ , transforming the formula to obtain $V' \approx \dfrac{I \Delta R}{\Delta t}$ , wherein $\Delta \eta$

represents the over-potential, I represents the output current at each collection moment, and $\Delta R$ represents the resistance change. In this case, the voltage drop per unit time corresponding to the lithium-ion battery is used to associate the SOC of the battery with the battery ageing, which can remove the number of cycles.

It can be seen that the implementation of the optional embodiment can calculate the voltage drop per unit time based on two adjacent output voltages, or calculate the resistance change of the lithium-ion battery after ageing based on the over-potential after the ageing of the lithium-ion battery, and calculate the voltage drop per unit time corresponding to the lithium-ion battery according to the resistance change and the output current at each collection moment. The resistance change is calculated by using the over-potential so as to reflect the ageing of the battery, and then associate the SOC of the battery with the battery ageing based on the voltage drop per unit time corresponding to the lithium-ion battery, avoiding using a battery cycle life parameter which is difficult to track to express the SOH of the battery, and reducing the difficulty in determining the SOC and the SOH of the battery, and improving determination accuracy and efficiency.

In another optional embodiment, the constructing an SOC calculation model of the lithium-ion battery based on the battery output information and the voltage drop per unit time may include the following operations:

performing a data regression fitting based on the battery output information to obtain SOC model coefficients of the lithium-ion battery; and
constructing the SOC calculation model of the lithium-ion battery based on the voltage drop per unit time and the SOC model coefficients.

The SOC calculation model includes:

$$ SOC(\%) = a * V + b * \left( \frac{1}{V'} \right) + c , $$

where, V represents the output voltage at each collection moment, and a, b and c represent the SOC model coefficients.

In the optional embodiment, optionally, the relationship between the SOC of the battery and the voltage and an inverse of the voltage drop per unit time is approximately linear, therefore, the SOC calculation model of the lithium-ion battery is set to be a linear equation, that is, $SOC(\%) = a * V + b * \left( \dfrac{1}{V'} \right) + c$ . The SOC model coefficients a, b, and c of the lithium-ion battery are obtained by performing a data regression fitting based on the battery output information.

It can be seen that the implementation of the optional embodiment can construct the SOC calculation model of the lithium-ion battery based on the voltage drop per unit time and the SOC model coefficients, thereby improving the accuracy of the SOC model, and improving the accuracy and efficiency of calculating the SOC of the battery at the same time.

Embodiment 3

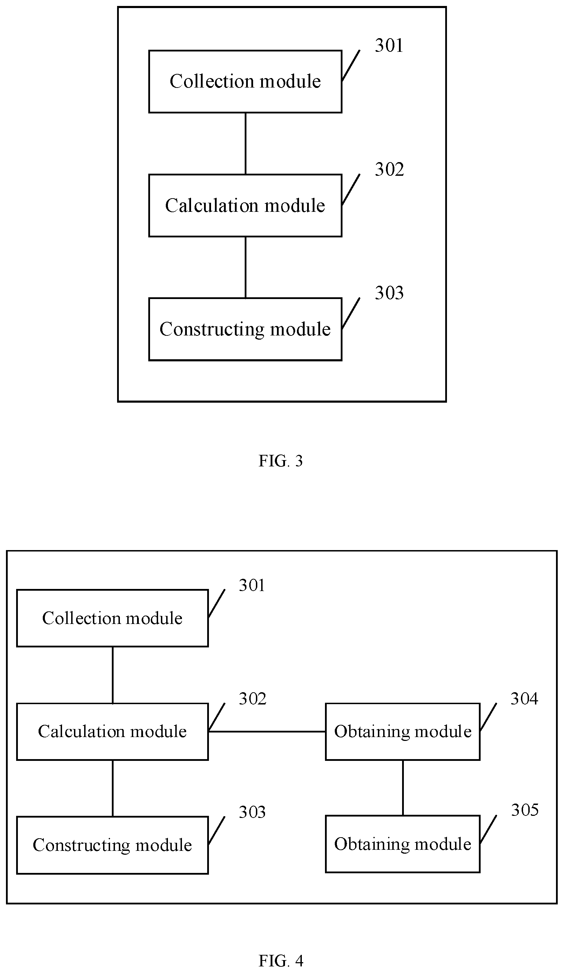

Please refer to FIG. 3, which is a schematic structural diagram of a device for estimating an SOC and an SOH of a lithium-ion battery according to the embodiments of the present disclosure. the device for estimating the SOC and the SOH of the lithium-ion battery described in FIG. 3 may include an intelligent server or an intelligent platform configured to estimate an SOC value and an SOH value of a lithium-ion battery. The intelligent server includes a local server or a cloud server, which is not limited in the embodiments of the present disclosure. As shown in FIG. 3, the device for estimating the SOC and the SOH of the lithium-ion battery may include:

a collection module 301 configured to collect battery output information of lithium-ion batteries at preset time intervals during a life cycle experiment on the lithium-ion batteries, where the battery output information includes an output current and an output voltage at each collection moment;
a calculation module 302 configured to calculate a voltage drop per unit time corresponding to the lithium-ion battery according to the battery output information, and construct an SOC calculation model of the lithium-ion battery based on the battery output information and the voltage drop per unit time;

a constructing module 303 configured to define a correction factor according to the SOC calculation model, and construct an SOH calculation model of the lithium-ion battery according to the battery output information, the voltage drop per unit time and the correction factor, wherein the SOC calculation model is configured to calculate SOC values of the lithium-ion batteries, and the SOH calculation model is configured to calculate SOH values of the lithium-ion batteries.

It can be seen that the device for estimating the SOC and the SOH of the lithium-ion battery as described in FIG. 3 can can collect the battery output information of the lithium-ion batteries at preset time intervals during the life cycle experiment on the lithium-ion batteries; calculate the voltage drop per unit time corresponding to the lithium-ion battery according to the battery output information, and construct the SOC calculation model of the lithium-ion battery based on the battery output information and the voltage drop per unit time; define the correction factor according to the SOC calculation model, and construct the SOH calculation model of the lithium-ion battery according to battery output information, the voltage drop per unit time and the correction factor. The SOC model and the SOH model can be defined based on a voltage drop per unit time of a new variable, and the instantaneous SOC and SOH of the battery are estimated online without performing a full cycle test on the batteries, thereby improving the efficiency and accuracy of determining the SOC and the SOH of the battery. Furthermore, modeling can be performed based on any one of the batteries in the same batch, and then estimate the SOCs and the SOHs of all the batteries. The model has high accuracy and robustness, and can improve the accuracy of online estimation of the SOC and the SOH of the lithium-ion battery.

In an optional embodiment, as shown in FIG. 4, a specific manner for the calculation module 302 to calculate the voltage drop per unit time corresponding to the lithium-ion battery according to the battery output information includes:

in an output voltage at each collection moment, calculating a voltage drop per unit time corresponding to the lithium-ion battery based on two adjacent output voltages; or,

determining an initial voltage of the lithium-ion battery, and calculating an over-potential of the lithium-ion battery after ageing according to the output voltage at each collection moment and the initial voltage;

calculating a resistance change of the lithium-ion battery after ageing according to the output current at each collection moment and the over-potential;

calculating the voltage drop per unit time corresponding to the lithium-ion battery according to the resistance change and the output current at each collection moment.

It can be seen that the device for estimating the SOC and the SOH of the lithium-ion battery as described in FIG. 4 can collect the battery output information of the lithium-ion batteries at preset time intervals during the life cycle experiment on the lithium-ion batteries; in an output voltage at each collection moment, calculate a voltage drop per unit time corresponding to the lithium-ion battery based on two adjacent output voltages; determine an initial voltage of the lithium-ion battery, and calculate an over-potential of the lithium-ion battery after ageing according to the output voltage at each collection moment and the initial voltage; calculate a resistance change of the lithium-ion battery after aging according to the output current at each collection moment and the over-potential; calculate the voltage drop per unit time corresponding to the lithium-ion battery according to the resistance change and the output current at each collection moment, so that the SOC of the battery can be associated with battery aging based on the voltage drop per unit time corresponding to the lithium-ion battery, avoiding using a battery cycle life parameter which is difficult to track to express the SOH of the battery, reducing the difficulty in determining the SOC and the SOH of the battery, and improving determination accuracy and efficiency; construct an SOC calculation model of the lithium-ion battery based on the battery output information and the voltage drop per unit time; define a correction factor according to the SOC calculation model, and construct an SOH calculation model of the lithium-ion battery according to the battery output information, the voltage drop per unit time and the correction factor. The SOC model and the SOH model can be defined based on a voltage drop per unit time of a new variable, and the instantaneous SOC and SOH of the battery are estimated online without performing a full cycle test on the battery, thereby improving the efficiency and accuracy of determining the SOC and the SOH of the battery. Furthermore, modeling can be performed based on any one of the batteries in the same batch, and then estimate the SOCs and the SOH of all the batteries. The model has high accuracy and robustness, and can improve the accuracy of online estimation of the SOC and the SOH of the lithium-ion battery.

In another optional embodiment, as shown in FIG. 4, in the output voltage at each collection moment, a calculation formula for the calculation module 302 to calculate the voltage drop per unit time corresponding to the lithium-ion battery based on two adjacent output voltages includes:

$$V' = \frac{\Delta V}{\Delta t}, \quad \Delta V = V1 - V2,$$

wherein V' represents the voltage drop per unit time, V1 and V2 represent the two adjacent output voltages, and $\Delta t$ represents the unit time.

A calculation formula for the calculation module 302 to calculate the voltage drop per unit time corresponding to the lithium-ion battery according to the resistance change and the output current at each collection moment includes:

$$V' \approx \frac{\Delta\eta}{\Delta t}\,, \quad \frac{V'}{I} \approx \frac{\Delta\eta/I}{\Delta t} = \frac{\Delta R}{\Delta t}\,, \quad V' \approx \frac{I\Delta R}{\Delta t}\,,$$

where $\Delta\eta$ represents the over-potential, I represents the output current at each collection moment, and $\Delta R$ represents the resistance change.

It can be seen that the device for estimating the SOC and the SOH of the lithium-ion battery as described in FIG. 4 can calculate the voltage drop per unit time based on two adjacent output voltages, or calculate the resistance change of the lithium-ion battery after ageing based on the over-potential after the ageing of the lithium-ion battery, and calculate the voltage drop per unit time corresponding to the lithium-ion battery according to the resistance change and the output current at each collection moment. The resistance change is calculated by using the over-potential so as to reflect the ageing of the battery, and then associate the SOC of the battery with the battery ageing based on the voltage drop per unit time corresponding to the lithium-ion battery, avoiding using a battery cycle life parameter which is difficult to track to express the SOH of the battery, and reducing the difficulty in determining the SOC and the SOH of the battery, and improving the determination accuracy and efficiency.

In another optional embodiment, as shown in FIG. 4, a specific manner for the calculation module 302 to construct the SOC calculation model of the lithium-ion battery based on the battery output information and the voltage drop per unit time includes:

performing a data regression fitting based on the battery output information to obtain SOC model coefficients of the lithium-ion battery; and
constructing the SOC calculation model of the lithium-ion battery based on the voltage drop per unit time and the SOC model coefficients.

The SOC calculation model includes:

$$SOC(\%) = a * V + b * \left(\frac{1}{V'}\right) + c\,,$$

where, V represents the output voltage at each collection moment, and a, b and c represent the SOC model coefficients.

It can be seen that the device for estimating the SOC and the SOH of the lithium-ion battery as described in FIG. 4 can construct the SOC calculation model of the lithium-ion battery based on the voltage drop per unit time and the SOC model coefficients, thereby improving the accuracy of the SOC model, and improving the accuracy and efficiency of calculating the SOC of the battery at the same time.

In another optional embodiment, as shown in FIG. 4, a specific manner for the constructing module 303 to construct the SOH calculation model of the lithium-ion battery according to the battery output information, the voltage drop per unit time, and the correction factor includes:

constructing an SOH regression model of the lithium-ion battery at a preset SOC level according to the battery output information and the voltage drop per unit time; and
constructing, based on the correction factor, the SOH calculation model of the lithium-ion battery based on the SOH regression model at a preset SOC level.

It can be seen that the device for estimating the SOC and the SOH of the lithium-ion battery as described in FIG. 4 can construct the SOH regression model of the lithium-ion battery at the preset SOC level according to the battery output information and the voltage drop per unit time; construct, based on the correction factor, the SOH calculation model of the lithium-ion battery based on the SOH regression model at the preset SOC level. The SOH calculation model can be constructed based on the correction factor newly defined in the SOC calculation model, thereby improving the accuracy of the SOH model, and improving the accuracy and efficiency of calculating the SOH of the battery at the same time.

In another optional embodiment, as shown in FIG. 4, a specific manner for the constructing module 303 to construct the SOH regression model of the lithium-ion battery at the preset SOC level according to the battery output information and the voltage drop per unit time includes:

performing a data regression fitting based on the battery output information to obtain SOH model coefficients of the lithium-ion battery; and

constructing the SOH regression model of the lithium-ion battery at the preset SOC level according to the voltage drop per unit time and the SOH model coefficients.

The SOH regression model include:

$$SOH(\%) = A*\left(\frac{1}{V'}\right) + B,$$

and the SOH calculation model includes:

$$SOH(\%) = \alpha(SOC)*\left[A*\left(\frac{1}{V'}\right) + B\right],$$

where A and B represent the SOH model coefficients, and $\alpha(SOC)$ represents the correction factor.

It can be seen that the device for estimating the SOC and the SOH of the lithium-ion battery as described in FIG. 4 can construct the SOH regression model of the lithium-ion battery at the preset SOC level according to the voltage drop per unit time and the SOH model coefficients, and then construct the SOH calculation model based on the correction factor newly defined by the SOC calculation model, which can improve the accuracy of the SOH model, and improve the accuracy and efficiency of calculating the SOH of the battery at the same time.

In another optional embodiment, as shown in FIG. 4, a specific manner for the constructing module 303 to define the correction factor according to the SOC calculation model includes:

performing a data regression fitting based on the SOC calculation model and the battery output information to obtain correction factor coefficients of the lithium-ion battery; and

defining the correction factor based on the correction factor coefficients and the SOC calculation model.

The formula for calculating the correction factor includes:

$$\alpha(SOC) = C_1(SOC)^3 + C_2(SOC)^2 + C_3(SOC)^1 + C_0,$$

where, $C_1$, $C_2$, $C_3$, and $C_0$ represent the correction factor coefficients.

It can be seen that the device for estimating the SOC and the SOH of the lithium-ion battery as described in FIG. 4 can perform a data regression fitting based on the SOC calculation model and the battery output information, so as to obtain the correction factor coefficients of the lithium-ion battery; and define the correction factor based on the correction factor coefficients and the SOC calculation model, which can improve the accuracy of the correction factor. In addition, the correction factor is introduced into the SOH calculation model, without the need to regress and calculate the model coefficients again, thereby improving model accuracy and the calculation efficiency.

In another optional embodiment, as shown in FIG. 4, the calculation module 302 is further configured to calculate battery test values of the lithium-ion battery according to the SOC calculation model and the SOH calculation model respectively, where the battery test values include an SOC test value and an SOH test value.

The device for estimating the SOC and the SOH of the lithium-ion battery can further include:

an obtaining module 304 configured to obtain battery verification values of the lithium-ion battery, and calculate model indexes corresponding to the SOC calculation model and the SOH calculation model respectively according to the battery test values and the battery verification values; where the battery verification values include an SOC verification value and an SOH verification value, and the model indexes include an average correlation coefficient and a root mean square error;

a verification module 305 configured to perform model verification on the SOC calculation model and the SOH calculation model respectively based on the model indexes corresponding to the SOC calculation model and the SOH calculation model to obtain a verification result, and perform model optimization on the SOC calculation model and the SOH calculation model based on the verification result.

It can be seen that the device for estimating the SOC and the SOH of the lithium-ion battery as described in FIG. 4 can perform model verification and optimization on the SOC calculation model and the SOH calculation model based on the average correlation coefficient and the root mean square error, reducing the deviation between the model prediction value and the actual value, and when using any one of the batteries in the same batch for model construction, the accuracy and precision of calculating the SOC and the SOH of the other batteries are similar, thereby improving the accuracy and precision of the model.

Embodiment 4

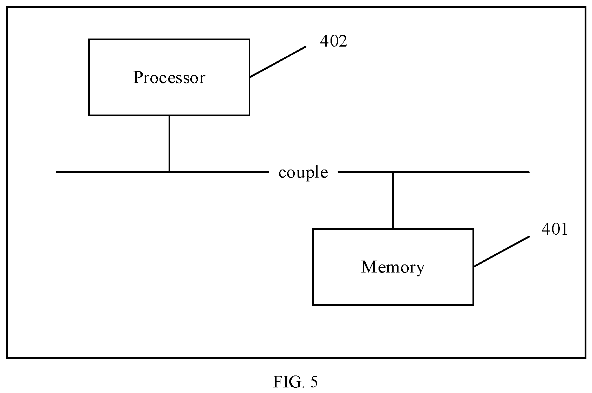

Please refer to FIG. 5, which is a schematic structural diagram of another device for estimating an SOC and an SOH of a lithium-ion battery according to the embodiments of the present disclosure. As shown in FIG. 5, the device for estimating the SOC and the SOH of the lithium-ion battery may include:

a memory 401 storing executable program codes; and
a processor 402 coupled to the memory 401.

The processor 402 calls the executable program codes stored in the memory 401 to execute steps of the method for estimating an SOC and an SOH of a lithium-ion battery described in embodiment 1 or embodiment 2 of the present disclosure.

Embodiment 5

The embodiments of the present disclosure disclose a computer storage medium. The computer storage medium stores computer instructions. When the computer instructions are called, the computer instructions are configured to execute steps of the method for estimating an SOC and an SOH of a lithium-ion battery described in embodiment 1 or embodiment 2 of the present disclosure.

Embodiment 6

The embodiments of the present disclosure disclose a computer program product. The computer program product includes a non-transitory computer-readable storage medium storing a computer program. The computer program is operable to enable a computer to execute steps of the method for estimating an SOC and an SOH of a lithium-ion battery described in embodiment 1 or embodiment 2.
The device embodiments described above are merely exemplary, where modules described as separate components may or may not be physically separated, and components displayed as modules may or may not be physical modules, that is, they may be located in one position, or may be distributed on a plurality of network modules. Some or all of the modules may be selected according to actual needs to achieve the objectives of the solutions of the embodiments. A person of ordinary skill in the art would have been able to understand and implement same without any creative effort.
Through the detailed description of the above embodiments, those skilled in the art may clearly understand that each embodiment may be implemented by means of software in addition to a necessary universal hardware platform, and definitely may also be implemented by hardware. Based on such understanding, the above technical solutions essentially or the part contributing to related technologies may be embodied in the form of a software product. The computer software product may be stored in a computer-readable storage medium, and the storage medium includes a read-only memory (ROM), a random access memory (RAM), a programmable read-only memory (PROM), an erasable programmable read-only memory (EPROM), a one-time programmable read-only memory (OTPROM), an electrically-erasable programmable read-only memory (EEPROM), a compact disc read-only memory (CD-ROM), or other optical disk storage, magnetic disk storage, magnetic tape storage, or any other medium that can be used to carry or store data for computer-readable storage.

**Claims**

1. A method for estimating an SOC and an SOH of a lithium-ion battery, the method comprising:

collecting battery output information of lithium-ion batteries at preset time intervals during a life cycle experiment on the lithium-ion batteries; wherein the battery output information comprises an output current and an output voltage at each acquisition moment;
calculating a voltage drop per unit time corresponding to the lithium-ion battery according to the battery output information, and constructing an SOC calculation model of the lithium-ion battery based on the battery output information and the voltage drop per unit time; and

defining a correction factor according to the SOC calculation model, and constructing an SOH calculation model of the lithium-ion battery according to the battery output information, the voltage drop per unit time and the correction factor;

wherein the SOC calculation model is configured to calculate SOC values of the lithium-ion batteries, and the SOH calculation model is configured to calculate SOH values of the lithium-ion batteries.

2. The method for estimating the SOC and the SOH of the lithium-ion battery according to claim 1, wherein the calculating a voltage drop per unit time corresponding to the lithium-ion battery according to the battery output information comprises:

in the output voltage at each collection moment, calculating the voltage drop per unit time corresponding to the lithium-ion battery based on two adjacent output voltages; or,

determining an initial voltage of the lithium-ion battery, and calculating an over-potential of the lithium-ion battery after ageing according to the output voltage at each collection moment and the initial voltage;

calculating a resistance change of the lithium-ion battery after aging according to the output current at each collection moment and the over potential; and

calculating the voltage drop per unit time corresponding to the lithium-ion battery according to the resistance change and the output current at each collecting moment.

3. The method for estimating the SOC and the SOH of the lithium-ion battery according to claim 2, wherein, in the output voltage at each collection moment, a calculation formula for calculating the voltage drop per unit time corresponding to the lithium-ion battery based on two adjacent output voltages comprises:

$$V' = \frac{\Delta V}{\Delta t}, \quad \Delta V = V1 - V2,$$

wherein V' represents the voltage drop per unit time, V1 and V2 represent the two adjacent output voltages, and $\Delta t$ represents the unit time;

a calculation formula for calculating the voltage drop per unit time corresponding to the lithium-ion battery according to the resistance change and the output current at each collecting moment comprises:

$$V' \approx \frac{\Delta \eta}{\Delta t}, \quad \frac{V'}{I} \approx \frac{\Delta \eta / I}{\Delta t} = \frac{\Delta R}{\Delta t}, \quad V' \approx \frac{I \Delta R}{\Delta t},$$

wherein $\Delta \eta$ represents the over-potential, I represents the output current at each of the collection moments, $\Delta R$ represents the resistance change.

4. The method for estimating the SOC and the SOH of the lithium-ion battery according to claim 3, wherein the constructing an SOC calculation model of the lithium-ion battery based on the battery output information and the voltage drop per unit time comprises:

performing a data regression fitting based on the battery output information to obtain SOC model coefficients of the lithium-ion battery; and

constructing the SOC calculation model of the lithium-ion battery based on the voltage drop per unit time and the SOC model coefficients;

wherein the SOC calculation model comprises:

$$SOC(\%) = a * V + b * \left(\frac{1}{V'}\right) + c,$$

wherein V represents the output voltage at each of the collection moments; and a, b and c represent SOC model coefficients.

5. The method for estimating the SOC and the SOH of the lithium-ion battery according to any one of claims 1 to 4, wherein the constructing an SOH calculation model of the lithium-ion battery according to the battery output information, the voltage drop per unit time and the correction factor comprises:

constructing an SOH regression model of the lithium-ion battery at a preset SOC level according to the battery output information and the voltage drop per unit time; and
constructing, based on the correction factor, the SOH calculation model of the lithium-ion battery based on the SOH regression model at the preset SOC level.

6. The method for estimating the SOC and the SOH of the lithium-ion battery according to claim 5, wherein the constructing an SOH regression model of the lithium-ion battery at a preset SOC level according to the battery output information and the voltage drop per unit time comprises:

performing a data regression fitting on the battery output information to obtain SOH model coefficients of the lithium-ion battery; and
constructing the SOH regression model of the lithium-ion battery at the preset SOC level according to the voltage drop per unit time and the SOH model coefficients;
wherein the SOH regression model comprises:

$$\mathrm{SOH}(\%) = \mathrm{A} * \left(\frac{1}{\mathrm{V}'}\right) + \mathrm{B},$$

and the SOH calculation model comprises:

$$\mathrm{SOH}(\%) = \alpha(\mathrm{SOC}) * \left[\mathrm{A} * \left(\frac{1}{\mathrm{V}'}\right) + \mathrm{B}\right],$$

wherein A and B represent the SOH model coefficients, and $\alpha(\mathrm{SOC})$ represents the correction factor.

7. The method for estimating the SOC and the SOH of the lithium-ion battery according to claim 6, wherein the defining a correction factor according to the SOC calculation model comprises:

performing a data regression fitting based on the SOC calculation model and the battery output information to obtain correction factor coefficients of the lithium-ion battery; and
defining the correction factor based on the correction factor coefficient and the SOC calculation model;
wherein a calculation formula for calculating the correction factor comprises:

$$\alpha(\mathrm{SOC}) = \mathrm{C}_1(\mathrm{SOC})^3 + \mathrm{C}_2(\mathrm{SOC})^2 + \mathrm{C}_3(\mathrm{SOC})^1 + \mathrm{C}_0,$$

wherein, $\mathrm{C}_1$, $\mathrm{C}_2$, $\mathrm{C}_3$, and $\mathrm{C}_0$ represent the correction factor coefficients.

8. The method for estimating the SOC and the SOH of the lithium-ion battery according to any one of claims 1 to 4, wherein the method further comprises:

calculating battery test values of the lithium-ion battery according to the SOC calculation model and the SOH calculation model respectively, wherein the battery test values comprise an SOC test value and an SOH test value;
obtaining battery verification values of the lithium-ion battery, and calculating model indexes corresponding to the SOC calculation model and the SOH calculation model respectively according to the battery test values and the battery verification values, wherein the battery verification values comprise an SOC verification value and an SOH verification value, and the model indexes comprise an average correlation coefficient and a root mean square error; and
performing model verification on the SOC calculation model and the SOH calculation model respectively based on the model indexes corresponding to the SOC calculation model and the SOH calculation model to obtain a verification result, and performing model optimization on the SOC calculation model and the SOH calculation model based on the verification result.

9. A device for estimating an SOC and an SOH of a lithium-ion battery, the device comprising:

a memory storing executable program codes; and
a processor coupled to the memory;
wherein the processor calls the executable program codes stored in the memory to execute the method for estimating the SOC and the SOH of the lithium-ion battery according to any one of claims 1 to 8.

10. A computer storage medium, wherein the computer storage medium stores computer instructions; when the computer instructions are called, the computer instructions are configured to execute the method for estimating the SOC and the SOH of the lithium-ion battery according to any one of claims 1 to 8.

Collecting battery output information of lithium-ion batteries at preset time intervals during a life cycle experiment on the lithium-ion batteries

101

Calculating a voltage drop per unit time corresponding to the lithium-ion battery according to the battery output information, and constructing an SOC calculation model of the lithium-ion battery based on the battery output information and the voltage drop per unit time

102

Defining a correction factor according to the SOC calculation model, and constructing an SOH calculation model of the lithium-ion battery according to the battery output information, the voltage drop per unit time and the correction factor

103

FIG. 1

Collecting battery output information of lithium-ion batteries at preset time intervals during a life cycle experiment on the lithium-ion batteries — 201

In an output voltage at each collection moment, calculating a voltage drop per unit time corresponding to the lithium-ion battery based on two adjacent output voltages — 202

Determining an initial voltage of the lithium-ion battery, and calculating an over-potential of the lithium-ion battery after ageing according to the output voltage at each collection moment and the initial voltage — 203

Calculating a resistance change of the lithium-ion battery after aging according to the output current at each collection moment and the over-potential — 204

Calculating the voltage drop per unit time corresponding to the lithium-ion battery according to the resistance change and the output current at each collection moment — 205

Constructing an SOC calculation model of the lithium-ion battery based on the battery output information and the voltage drop per unit time — 206

Defining a correction factor according to the SOC calculation model, and constructing an SOH calculation model of the lithium-ion battery according to the battery output information, the voltage drop per unit time and the correction factor — 207

FIG. 2

Collection module ⟋ 301

Calculation module ⟋ 302

Constructing module ⟋ 303

FIG. 3

Collection module ⟋ 301

Calculation module ⟋ 302

Constructing module ⟋ 303

Obtaining module ⟋ 304

Obtaining module ⟋ 305

FIG. 4

FIG. 5

TRANSLATION

## INTERNATIONAL SEARCH REPORT

| International application No. |
| --- |
| **PCT/CN2024/137238** |

| A. | CLASSIFICATION OF SUBJECT MATTER |
| --- | --- |

G01R31/36(2020.01)i; G01R31/392(2019.01)i; G01R31/388(2019.01)i

According to International Patent Classification (IPC) or to both national classification and IPC

| B. | FIELDS SEARCHED |
| --- | --- |

Minimum documentation searched (classification system followed by classification symbols)

IPC: G01R31/-

Documentation searched other than minimum documentation to the extent that such documents are included in the fields searched

Electronic data base consulted during the international search (name of data base and, where practicable, search terms used)

CNTXT, ENTXTC, DWPI, CNKI: 荷电状态, SOC, SOH, 健康, 单位时间, 单位时长, 预设时长, 预定时长, 预设时间, 预定时间, 预设间隔, 预定间隔, 压降, 压差, 电压下降, 电压下降率, 压降率, 电压, 变化率, 斜率, 过压, 过电位, 过电压, 极化电压, 电阻, 内阻, 变化, 改变, 上升, 下降, 增大, 减小, 差, state of charge, health, unit time, rate, voltage, chang???, drop, slope, overpotential, polarization voltage, resistance

| C. | DOCUMENTS CONSIDERED TO BE RELEVANT | |
| --- | --- | --- |
| Category* | Citation of document, with indication, where appropriate, of the relevant passages | Relevant to claim No. |
| Y | CN 117420457 A (JIANGSU ZENERGY BATTERY TECHNOLOGIES CO., LTD.) 19 January 2024 (2024-01-19)<br>description, paragraphs [0029]-[0075], and figures 1-5 | 1-3, 8-10 |
| Y | CN 110988690 A (CONTEMPORARY AMPEREX TECHNOLOGY CO., LTD.) 10 April 2020 (2020-04-10)<br>description, paragraph [0162] | 1-3, 8-10 |
| A | CN 111308364 A (CENTRAL SOUTH UNIVERSITY) 19 June 2020 (2020-06-19)<br>entire document | 1-10 |
| A | CN 117930008 A (CENTRAL SOUTH UNIVERSITY) 26 April 2024 (2024-04-26)<br>entire document | 1-10 |
| A | CN 118191637 A (SHENZHEN WENCHU INNOVATION TECHNOLOGY CO., LTD.) 14 June 2024 (2024-06-14)<br>entire document | 1-10 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 April 2025** | **25 April 2025** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**TRANSLATION**

**INTERNATIONAL SEARCH REPORT**

| International application No. |
| --- |
| **PCT/CN2024/137238** |

**C.  DOCUMENTS CONSIDERED TO BE RELEVANT**

| Category* | Citation of document, with indication, where appropriate, of the relevant passages | Relevant to claim No. |
| --- | --- | --- |
| A | CN 108226783 A (BYD CO., LTD.) 29 June 2018 (2018-06-29)<br>entire document | 1-20 |
| A | CN 117269810 A (DR. OCTOPUS INTELLIGENT TECHNOLOGY (SHANGHAI) CO., LTD.) 22 December 2023 (2023-12-22)<br>entire document | 1-10 |
| A | JP 2023121369 A (TOYOTA INDUSTRIES CORP.) 31 August 2023 (2023-08-31)<br>entire document | 1-10 |

Form PCT/ISA/210 (second sheet) (July 2022)

**INTERNATIONAL SEARCH REPORT**
**Information on patent family members**

International application No.

**PCT/CN2024/137238**

| Patent document cited in search report | | | Publication date (day/month/year) | Patent family member(s) | | | Publication date (day/month/year) |
|---|---|---|---|---|---|---|---|
| CN | 117420457 | A | 19 January 2024 | None | | | |
| CN | 110988690 | A | 10 April 2020 | US | 2021141028 | A1 | 13 May 2021 |
| | | | | US | 11656289 | B2 | 23 May 2023 |
| | | | | EP | 3779484 | A1 | 17 February 2021 |
| | | | | EP | 3779484 | B1 | 30 November 2022 |
| | | | | WO | 2020216082 | A1 | 29 October 2020 |
| CN | 111308364 | A | 19 June 2020 | None | | | |
| CN | 117930008 | A | 26 April 2024 | None | | | |
| CN | 118191637 | A | 14 June 2024 | None | | | |
| CN | 108226783 | A | 29 June 2018 | None | | | |
| CN | 117269810 | A | 22 December 2023 | None | | | |
| JP | 2023121369 | A | 31 August 2023 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411390872